## Europäisches Patentamt

## European Patent Office

## Office européen des brevets

(11) Numéro de publication: **0 039 275
B1**

(12) **FASCICULE DE BREVET EUROPEEN**

(45) Date de publication du fascicule du brevet:
04.04.84

(21) Numéro de dépôt: **81400612.8**

(22) Date de dépôt: **16.04.81**

(51) Int. Cl.³: **H 03 D 3/24,** H 03 J 5/02,
H 04 B 1/16

(54) Dispositif de synthèse et de démodulation combinées pour récepteur d'ondes modulées en fréquence, et récepteur le comportant.

(30) Priorité: **25.04.80 FR 8009387**

(43) Date de publication de la demande:
**04.11.81 Bulletin 81/44**

(45) Mention de la délivrance du brevet:
**04.04.84 Bulletin 84/14**

(84) Etats contractants désignés:
**AT DE GB SE**

(56) Documents cités:
**FR - A - 1 443 419
FR - A - 2 115 283
FR - A - 2 175 671
FR - A - 2 304 213
US - A - 3 212 023**

**ELEKTOR, volume 2, no. 1, publié par ELEKTOR
PUBLISHERS LTD., janvier 1976 Canterbury, G.B.
ANON: "Feedback pll for fm", pages 110-119
IEEE TRANSACTIONS ON CONSUMER ELECTRONICS;
volume 22, no. 1, février 1976 New York, U.S.A. S.
HILLIKER: "A uniquely simplified TV tuning system
incorporating an equally unique digital automatic and
manual fine tuning scheme"**

(73) Titulaire: **THOMSON-BRANDT, 173, Boulevard
Haussmann, F-75379 Paris Cedex 08 (FR)**

(72) Inventeur: **Dutasta, Rémi, Thomson-CSF SCPI 173, bld
Haussmann, F-75360 Paris Cedex 08 (FR)**

(74) Mandataire: **Schmolka, Robert et al, THOMSON-CSF
SCPI 173, Bld Haussmann, F-75379 Paris Cedex 08 (FR)**

(56) Documents cités: (suite)
**TOUTE L'ELECTRONIQUE, no. 419, mars 1977 Paris, FR.
J. ZAKHEIM: "La boucle à verrouillage de phase",
pages 43-50
IEEE TRANSACTIONS ON MICROWAVE THEORY AND
TECHNIQUES, volume MTT-25, no. 12, décembre 1977
New York, U.S.A. R.J. DOUVILLE: "A 12-GHz low-cost
earth terminal for direct TV reception from broadcast
satellites", pages 1000-1008**

Dispositif de synthèse et de démodulation combinées pour récepteur d'ondes modulées en fréquence et
récepteur le comportant

La présente invention concerne un dispositif de synthèse et de démodulation de fréquence combinées pour récepteur d'ondes modulées en fréquence du type comprenant deux boucles à verrouillage de phase (appelées »phase-locked loops« ou »PLL« dans la littérature anglo-américaine) respectivement utilisées comme synthétiseur de fréquence pour l'oscillateur local et comme démodulateur de fréquence à seuil amélioré.

L'utilisation des boucles à verrouillage de phase comme synthétiseurs de fréquence dans des dispositifs d'accord (sélecteurs de canaux) de récepteurs radio-fréquence est bien connue et décrite, par exemple, dans un article de BREEZE aux pages 24 à 32 de la revue américaine »IEEE TRANSACTIONS ON CONSUMER ELECTRONICS«, Vol. CE-24, N°. 1 du mois de février 1978, ou de HILLIKER aux pages 62 à 68 du Vol. CE-22, N°. 1 de la même revue, datée du mois de février 1976, ou dans les publications FR-A-2 236 318, 2 327 670 et 2 357 105. Par ailleurs, leur utilisation en tant que démodulateurs d'ondes modulées en fréquence est également bien connue et décrite, par exemple, dans des articles de NIEPOLD aux pages 245 à 253 de la revue allemande »ARCHIVE DER ELEKTRONIK UND ÜBERTRAGUNGSTECHNIK«, Vol. 31, cahier 6, du mois de juin 1977, ou de DOSWALD et WEHRLI aux pages 96 et 106 de la revue suisse »TECHNISCHE MITTEILUNGEN PTT«, Vol. 52, N°. 3, du mois de mars 1974 et de BREMENSON et DEHAENE aux pages 479 à 509 de la revue française »REVUE TECHNIQUE THOMSON-CSF«, Vol. 10, N°. 3, du mois de septembre 1978, ainsi que dans des publications FR-A-1 222 053 et US-A-3 069 625 correspondantes, ou FR-A-1 443 419 ou encore FR-A-2 180 001.

Les deux utilisations précitées de la boucle à verrouillage de phase ont été décrites dans les articles de ZAKHEIM aux pages 43 à 50 de la revue française »TOUTE L'ELECTRONIQUE« N°. 419 du mois de mars 1977 ou de MURTHI aux pages 59 à 64 de la revue américaine »EDN«, Vol. 22, N°. 16, datée du 5 septembre 1977.

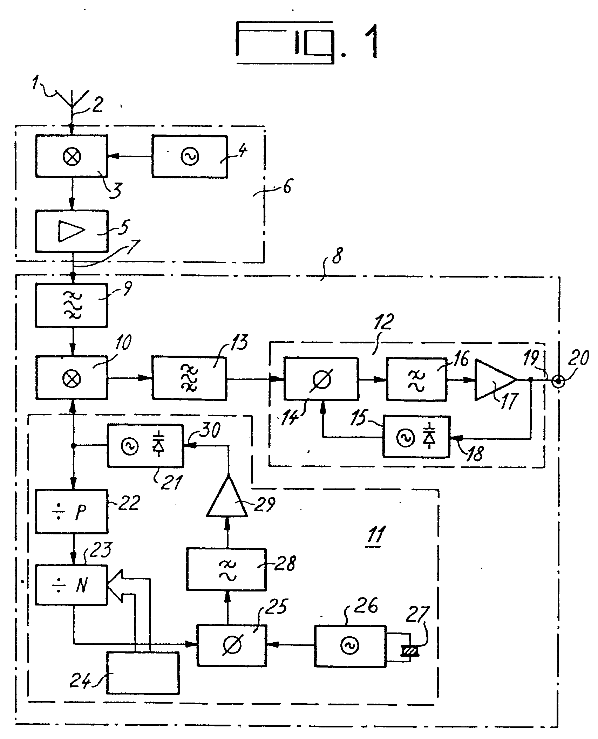

Selon la technique antérieure, représentée notamment par l'article de ZAKHEIM précité (voir préambule de la revendication 1), des récepteurs d'ondes modulées en fréquence peuvent donc utiliser deux boucles à verrouillage de phase indépendantes, l'une pour la synthèse de fréquence de l'oscillateur local du convertisseur hétérodyne et l'autre pour la démodulation de fréquence, comme illustré sur la figure 1 du dessin annexé, qui sera décrite plus loin. Un tel agencement présente l'inconvénient de permettre, lorsque la bande passante des éléments de filtrage passe-bande en amont du démodulateur à boucle de verrouillage de phase est insuffisamment sélective et/ou le signal reçu d'un canal de fréquence proche est assez intense, à cette boucle de se verrouiller sur la fréquence de cet autre signal qui est différente de celle choisie à l'aide du diviseur programmable du synthétiseur de fréquence alimentant le mélangeur hétérodyne dont le facteur de division est affiché en tant que le numéro du canal reçu. Cet accrochage à une fréquence différente de celle désirée est également possible lorsque l'oscillateur commandé du démodulateur à boucle de verrouillage de phase est accordable à l'aide d'une tension provenant d'un potentiomètre ou d'un synthétiseur de tensions d'accord à commande numérique, utilisée pour polariser sa diode à capacité variable à l'envers.

L'agencement combiné du dispositif d'accord et du démodulateur suivant la présente invention permet d'éviter cet inconvénient tout en procurant une économie de moyens.

On connaît un circuit oscillateur à stabilisation numérique, décrit dans la publication US-A-3 212 023, dans lequel une première boucle à verrouillage de phase utilisée pour la synthèse de fréquence et comprenant un premier filtre de boucle passe-bas à faible bande passante, détermine la fréquence d'oscillation d'un oscillateur commandé par tension en comparant la fréquence d'une onde fournie par un diviseur commutable qu'il alimente, à une onde de référence à fréquence constante. Ce circuit comporte, en outre, une seconde boucle à verrouillage de phase, dite auxiliaire dans laquelle la phase de l'onde fournie par l'oscillateur est comparée à celle d'une harmonique supérieure de l'onde de référence et le signal résultant de cette comparaison est appliqué à travers un second filtre de boucle haute-fréquence, ajouté à celui provenant du premier filtre de la boucle de synthèse, à l'entrée de commande de la fréquence de l'oscillateur par tension. On obtient ainsi l'élimination de la modulation parasite de la phase (dit »jitter« en anglais) de l'onde fournie par l'oscillateur, qui est dûe au diviseur commutable de la boucle de synthèse.

L'invention a pour objet un dispositif de synthèse et de démodulation de fréquence pour un récepteur d'ondes modulées en fréquence, comprenant: un oscillateur à fréquence variable commandée par tension; un premier comparateur de phase dont une entrée reçoit l'onde modulée en fréquence et dont l'autre entrée reçoit l'onde fournie par l'oscillateur; un premier filtre passe-bas ou passe-bande alimenté par la sortie du premier comparateur de phase; un prédiviseur de fréquence à facteur de division constante et un diviseur programmable à facteur de division variable commandé numériquement par un circuit de commande, connectés en cascade; un second comparateur de phase dont une entrée est alimentée par le diviseur programmable et dont l'autre entrée reçoit une onde de référence de fréquence stable provenant d'un oscillateur à quartz; et un second filtre passe-bas alimenté par la sortie du second comparateur de phase.

Suivant l'invention, la sortie de l'oscillateur alimente également le prédiviseur et les sorties du premier et du second filtre alimentent respectivement deux entrées d'un circuit additionneur analogique dont la sortie alimente l'entrée de commande de fréquence de l'oscillateur, de sorte que les deux boucles à verrouillage de phase respectivement de synthèse et de démodulation de fréquence sont combinées du fait qu'elles se referment à travers le même oscillateur.

Dans un mode de réalisation avantageux, le dispositif de synthèse et de démodulation de fréquence combinées des deux paragraphes précédents comporte, en outre, inséré dans la voie de l'onde modulée reçue, en amont du premier comparateur de phase, un filtre passe-bande accordable commandé par une tension continue d'accord qui est obtenue à partir du signal numérique commandant le facteur de division du diviseur programmable qui, appliqué aux entrées d'adresse parallèles d'une mémoire morte préprogrammée, engendre sur les sorties de données parallèles de celle-ci, un autre signal numérique appliqué aux entrées parallèles d'un convertisseur numérique-analogique. La sortie unique de ce convertisseur est reliée à l'entrée de commande d'accord du filtre accordable afin de lui fournir une tension d'accord telle que la fréquence centrale de la bande passante de ce filtre corresponde sensiblement à la fréquence de l'oscillateur commandé par tension en l'absence d'ondes modulées à l'entrée du premier comparateur de phase.

Dans un autre mode de réalisation de l'invention, le dispositif de synthèse et de démodulation de fréquence du paragraphe précédent comporte, en outre, inséré dans la voie de l'onde modulée reçue, en amont du premier comparateur de phase, un étage à gain variable en fonction d'un signal de commande, tel qu'un atténuateur haute-fréquence équipé de diodes PIN, dont l'entrée de commande de gain reçoit un signal de grandeur proportionnelle à l'amplitude de l'onde modulée qui est appliquée à l'entrée du premier comparateur, après son passage éventuel par le filtre passe-bande accordable, afin de la maintenir sensiblement constante à l'aide d'une boucle de commande automatique de gain ainsi formée.

L'invention sera mieux comprise et d'autres de ses objets, caractéristiques et avantages ressortiront de la description qui suit et des dessins annexés, donnés à titre d'exemple non-limitatif, sur lesquels:

— la figure 1 est un schéma synoptique (bloc-diagramme) partiel d'un récepteur d'ondes modulées en fréquence de l'art antérieur comprenant un dispositif d'accord à convertisseur hétérodyne (transposeur) muni d'un synthétiseur de fréquence avec une première boucle à verrouillage de phase de type à commande numérique en tant qu'oscillateur local, et un démodulateur de fréquence avec une seconde boucle à verrouillage de phase, les deux boucles étant indépendantes l'une de l'autre et;

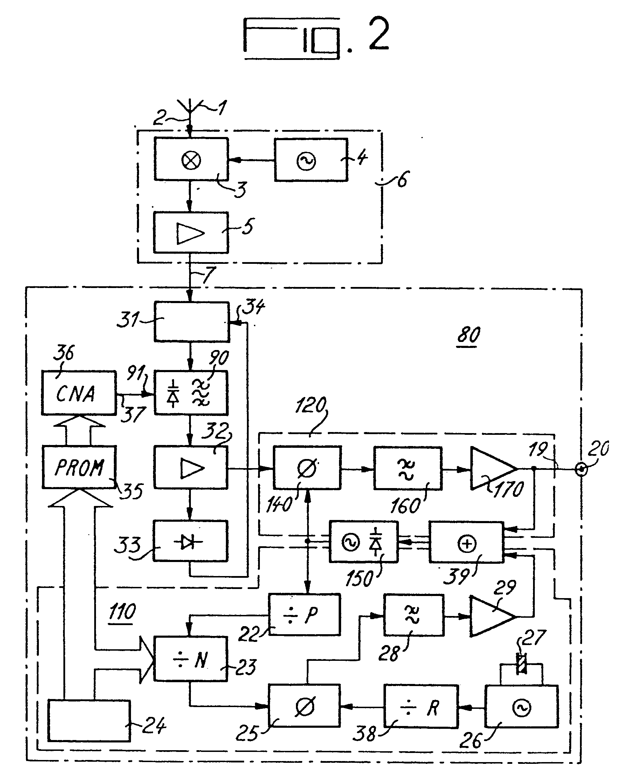

— la figure 2 représente le schéma synoptique partiel d'un récepteur d'ondes modulées en fréquence comprenant un dispositif de synthèse et de démodulation de fréquence combinées, suivant la présente invention.

Sur les figures précitées qui représentent des récepteurs d'ondes modulées en fréquence, destinés notamment à la réception directe des signaux de télévision émis par un satellite qui constitue une des applications modernes possibles d'un tel dispositif, les éléments correspondants ont été désignés par les mêmes nombres de repère.

Sur la figure 1, on a représenté schématiquement une partie d'un récepteur d'ondes modulées en fréquence pouvant être utilisé pour des liaisons hertziennes spatiales (par satellite), troposphériques ou autres, dont les porteuses ont des fréquences de plusieurs gigahertz (GHz ou kMHz), telles que, par exemple, celles situées dans la bande de 12 GHz définie par la Conférence du CCIR à Genève en 1977, comme celle allant de 11,7 à 12,3 GHz qui a été utilisée expérimentalement au Canada pour essayer la possibilité d'une réception directe du signal émis par un satellite de radiodiffusion (de programmes de télévision) géostationnaire. Cette expérience et les récepteurs utilisés ont été décrits dans de nombreux articles, tels que ceux de FREEMAN aux pages 234 à 236 de la revue britannique »THE RADIO AND ELECTRONIC ENGINEER«, Vol. 47, N°. 5 du mois de mai 1977; de DOUVILLE dans la revue américaine »IEEE TRANSACTIONS ON MICROWAVE THEORY AND TECHNIQUES«, Vol. MTT-25, N°. 12, du mois de décembre 1977; de KONISHI aux pages 720 à 725 du Vol. MTT-26, N°. 10 de la revue précédente, du mois d'octobre 1978, de HAWKER aux pages 27 à 35 de la revue britannique »IBA TECHNICAL REVIEW« N°. 11, du mois de juillet 1978; et de HALAYKO et HUCK aux pages 112 à 119 de la revue américaine »IEEE TRANSACTIONS ON CABLE TELEVISION«, Vol. CATV-3, N°. 3, du mois de juillet 1978, par exemple.

Un tel système de réception individuelle de signaux de télévision modulant une onde porteuse en fréquence qui est réémise par un satellite, comprend généralement une antenne 1 représentée symboliquement, dite de type parabolique, c'est-à-dire comportant un réflecteur en forme de paraboloïde de révolution de diamètre pouvant être compris entre 0,7 et 1,6 mètres, par exemple, qui réfléchit vers son foyer les ondes électromagnétiques incidentes. Dans le foyer est situé l'ouverture d'un cornet ou un doublet captant l'énergie focalisée par le réflecteur et la transmettant par l'intermédiaire d'un guide d'onde 2 à un mélangeur ou convertisseur hétérodyne 3 à faible bruit, équipé d'au moins une diode de Schottky (en arséniure de gallium), ou un mélangeur équilibré à deux ou quatre de telles diodes, destiné à transposer la fréquence porteuse de la bande de 12 GHz vers une fréquence moins élevée. Le mélangeur-transposeur 3 est à cette fin alimenté, en outre, par un premier oscillateur local 4 à fréquence très stable, tel qu'un oscillateur équipé d'une diode de Gunn et muni d'une cavité résonnante qui peut, éventuellement, être excitée par des signaux de fréquence stable provenant d'un oscillateur à quartz par l'intermédiaire d'au moins un multiplicateur de fréquence pour fournir une onde à 10,8 GHz, par exemple (voir, par exemple, les articles précités de KONISHI, de HALAYKO et al., de DOSWALD et al. ou de FREEMAN). La sortie du mélangeur 3 qui transpose les fréquences des ondes porteuses de la bande de 11,7 à 12,2 GHz vers une bande de fréquences allant de 0,9 à 1,4 GHz, par exemple (voir les articles de HAWKER, KONISHI et HALAYKO et al.), alimente une voie à fréquence intermédiaire comprenant l'ensemble des canaux de la bande. Cette première fréquence intermédiaire permet de transmettre tous les signaux à l'aide d'un premier amplificateur de fréquence intermédiaire 5 à large bande passante (B 500 MHz), alimenté par la sortie du mélangeur-transposeur 3. Les éléments 3, 4 et 5 décrits ci-dessus sont généralement contenus dans un boîtier blindé (et étanche) contenant la partie amont ou tête haute-fréquence 6 du récepteur, qui est fixé à l'arrière du réflecteur de l'antenne 1 et reliés, en ce que concerne les signaux à la première fréquence intermédiaire fournis par la sortie de l'amplificateur 5, ainsi qu'une tension d'alimentation continue, à la partie aval 8 du récepteur, au moyen d'un câble d'interconnexion coaxial 7. La première fréquence intermédiaire peut également occuper une bande autour de 450 MHz (voir l'article de HAWKER) en fonction du nombre de canaux jouxtants à recevoir.

Dans les articles précités de FREEMAN, KONISHI ou HAWKER, le récepteur comporte, en outre, un second mélangeur-convertisseur hétérodyne 10 dont une entrée est alimenté par les premiers signaux à fréquence intermédiaire, éventuellement par l'intermédiaire d'un premier filtre passe-bande 9, par exemple, et dont l'autre entrée est alimentée par un second oscillateur local accordable 11 destiné à choisir le canal devant contenir l'onde modulée en fréquence transmise vers un démodulateur de fréquence 12 à travers un second élément de filtrage et/ou d'amplification sélective 13, de préférence, muni d'un dispositif de commande automatique de gain efficace, dont la bande passante, centrée sur la seconde fréquence intermédiaire (située aux environs de 120 MHz, par exemple), présente une largeur correspondant sensiblement à celle du spectre d'une onde porteuse modulée en fréquence (≥ 20 MHz environ) par le signal de télévision (vidéo composite et son).

Le premier filtre passe-bande 9 est soit fixe et à large bande passante (500 ou 200 MHz) centrée sur la première fréquence intermédiaire (1,15 GHz ou 410 MHZ, par exemple) ou à bande passante étroite (au moins 20 MHz) et accordable à l'intérieur de la large bande susmentionnée à l'aide d'une tension d'accord polarisant une ou plusieurs diodes à capacté variable à l'envers. Le premier filtre 9 est alors accordé simultanément avec l'oscillateur local 11, constitué ici par un synthétiseur de fréquence à boucle de verrouillage de phase (PLL) classique, qui sera décrit plus loin.

Le démodulateur de fréquence 12 est alimenté par la sortie du second filtre à fréquence intermédiaire 13 reliée à son entrée qui est constituée ici par une première entrée d'un premier comparateur de phase 14 dont la seconde entrée est alimentée par la sortie d'un premier oscillateur à fréquence commandée par tension (VCO) 15. La sortie du premier comparateur de phase 14 alimente un premier filtre passe-bas 16 dont la fréquence de coupure ne doit pas être inférieure à la fréquence la plus élevée du signal modulant l'onde porteuse en fréquence. La sortie du premier filtre passe-bas 16 alimente, par l'intermédiaire d'un premier amplificateur à courant continu 17, d'une part, l'entrée de commande de fréquence 18 de l'oscillateur commandé (VCO) 15 et, d'autre part, la sortie 19 du démodulateur 12 fournissant le signal modulant. Le démodulateur 12 constitue ainsi une première boucle à verrouillage de phase (et de fréquence) dont l'oscillateur 15 suit les excursions de fréquence de l'onde porteuse transposée, modulée en fréquence, à l'aide d'un signal de commande appliqué à son entrée qui est dérivé du signal d'erreur fourni par le premier comparateur de phase 14 et qui correspond au signal modulant à un niveau de tension continue près. L'utilisation d'un démodulateur de fréquence à boucle de verrouillage de phase dans les liaisons par satellite a été préconisée dans l'article précité de DOSWALD et al. (page 108).

La sortie 19 du démodulateur de fréquence 12 est reliée à une sortie désignée par le repère 20, qui fournit le signal vidéo-composite de couleur ainsi qu'une sous-porteuse de son modulée en fréquence (5,14 MHz — voir FREEMAN, HALAYKO ou HAWKER) par le signal sonore (audio-fréquence).

Le second oscillateur local 11 ou synthétiseur de fréquence est agencé de la façon décrite dans les articles précités de HILLIKER et de BREEZE. Il comporte un second oscillateur commandé par une tension (VCO) 21 dont la sortie alimente, d'une part, l'une des entrées du second mélangeur hétérodyne 10 et, d'autre part, l'entrée d'un prédiviseur 22 à facteur de division fixe (P) et entier (appelé »prescaler« dans la littérature anglo-américaine), dont la sortie alimente l'entrée d'un diviseur programmable 23 à commande numérique.

Le facteur de division (N) variable et entier du diviseur programmable 23 est commandé par des nombres composés de signaux logiques appliqués à ses enrées de commande parallèles en provenance d'un circuit de commande numérique 24 classique comprenant un clavier décimal permettant d'afficher le numéro du canal que l'on désire recevoir, par l'actionnement successif des touches de ce clavier.

La sortie du diviseur programmable 23 alimente une première entrée d'un second comparateur de phase 25 (et de fréquence) dont la seconde entrée est alimentée par un oscillateur de référence 26 dont la fréquence très stable $F_Q$ est déterminée par quartz 27. Cette fréquence $F_Q$ détermine le pas avec lequel peut varier la fréquence de l'oscillateur local dont la fréquence $F_{LO}$ est égale $P.N.F_Q$, où $P$ et $F_Q$ sont constants et $N$ variable par nombres entiers.

La sortie du second comparateur de phase 25 alimente un second filtre passe-bas 28 (ou intégrateur) suivi d'un second amplificateur à courant continu 29 en cascade qui peuvent être combinés sous la forme d'un filtre passe-bas actif réalisé à l'aide d'un amplificateur opérationnel intégré dont la fréquence de coupure relativement peu élevée dépend de la vitesse de l'accrochage désirée lors d'un changement de canal. La sortie du second amplificateur à courant continu 29 alimente l'entrée de commande de la fréquence 30 du second oscillateur commandé 21 (VCO).

Comme il a été dit précédemment, si le second 13 et, éventuellement, le premier filtre 9 sont insuffisamment sélectifs et/ou lorsque l'amplitude de l'onde modulée est trop faible ou nulle, le démodulateur 12 à boucle de verrouillage de phase peut se verrouiller sur le signal d'un canal voisin ou sur un produit d'intermodulations quelconques et le signal fourni par la sortie 20 n'est pas celui transmis par le canal affiché par le circuit de commande numérique 24.

Sur la figure 2, on a représenté schématiquement un récepteur analogue muni d'un agencement combiné du dispositif d'accord par synthèse et du démodulateur de fréquence, conformément à l'invention, qui permet d'assurer que la boucle du démodulateur ne se verrouille que sur la fréquence porteuse du canal choisi à l'aide du diviseur programmable.

La sortie de la tête haute-fréquence 6 du récepteur de la figure 2 est également reliée par câble 7 à la partie aval 80 dont le premier étage est un élément à gain variable 31 à large bande passante (500 MHz) tel qu'un atténuateur à diodes PIN, par exemple, dont l'affaiblissement est commandé par une tension continue appliquée à son entrée de commande 34. La commande de l'atténuateur variable 31 peut également s'effectuer numériquement en appliquant l'amplitude détectée de la porteuse à un convertisseur analogique-numérique (non représenté). La sortie de l'atténuateur 31 alimente un filtre passe-bande accordable 90 dans la bande de 0,9 à 1,4 GHz et ayant une bande passante étroite ($\geq 20$ MHz) ne laissant passer que l'onde porteuse modulée d'un seul canal. L'accord du filtre 90 est effectué à l'aide d'une tension continue d'accord appliquée à son entrée de commande d'accord 91, qui polarise la ou les diodes à capacité variable qu'il comporte pour que la fréquence centrale de sa bande passante corresponde sensiblement à la fréquence de la porteuse non modulée du canal choisi.

La sortie du filtre passe-bande 90 alimente l'entrée d'un amplificateur à large bande 32 (500 MHz autour de 1,15 GHz environ) dont deux sorties alimentent, d'une part, la première entrée du premier comparateur de phase 140 appartenant à la boucle de démodulation 120 et, d'autre part, un circuit de commande 33 de l'atténuateur variable 31. Ce circuit de commande 33 comporte un détecteur d'amplitude (ou de crêtes) de la porteuse modulée, un filtre passe-bas (ou intégrateur) et, éventuellement, un amplificateur à courant continu, en cascade, (ces deux derniers éléments pouvant être constitués par un filtre activ) dont la sortie alimente l'entrée de commande de gain 34 de l'atténuateur 31 par une tension continue proportionnelle à l'amplitude de la porteuse afin que son atténuation (l'inverse du gain) le soit également. On obtient ainsi une commande automatique de gain très efficace, qui permet d'assurer à la porteuse modulée appliquée au démodulateur 120 une amplitude sensiblement constante pour des variations dans une large gamme de l'intensité du signal d'entrée du récepteur.

La seconde entrée du premier comparateur de phase 140 est reliée à la sortie de l'unique oscillateur commandé par tension (VCO) 150 qui est commun à la boucle de démodulation 120 et à celle de synthèse de fréquence 110 du récepteur, qui doit alors osciller dans la bande de fréquences de 0,9 à 1,4 GHz environ. Ceci est important pour le choix des composants qui l'équipent (transistors haute-fréquence, diodes à capacité variable) et de la configuration du premier comparateur de phase 140 qui est, de préférence, un mélangeur symétrique (du type en anneau, par exemple, appelé »balanced mixer« dans la littérature anglo-américaine) et, de ce fait, non-linéaire, comme décrit dans l'article de BREMENSON et al. précité.

La sortie du premier comparateur de phase 140 alimente un premier filtre passe-bas passif 160 dont la bande passante doit comprendre la bande de fréquences du signal vidéo-composite de couleur (5 MHz environ) et la sous-porteuse de son modulée en fréquence (à 5,5 MHz). Ce premier filtre 160 peut être réalisé sous la forme d'un filtre passe-bande dont la fréquence de coupure inférieure serait inférieure à 50 Hz et la supérieure serait supérieure à 5,3 MHz, par exemple. Il peut donc comporter un condensateur de couplage en série dans la voie du signal dit »d'erreur« fourni par le premier comparateur 140. La sortie du premier filtre passe-bas ou passe-bande 160 alimente, éventuellement par l'intermédiaire d'un amplificateur vidéo-fréquence 170, une première entrée d'un additionneur analogique ou sommateur 39 qui permet d'additionner ou de combiner les signaux ou tensions provenant des deux boucles 110 et 120 pour appliquer leur somme à l'entrée de commande de la fréquence de l'oscillateur commandé par tension 150.

La sortie de cet oscillateur 150 alimente également, par l'intermédiaire du prédiviseur 22 et du diviseur programmable 23 en cascade, la première entrée du second comparateur de phase (et de fréquence) 25 qui travaille à une fréquence notablement moins élevée que le premier 140. L'autre entrée du second comparateur de phase 25 est alimenté par l'oscillateur de référence 26 à quartz 27 par l'intermédiaire d'un diviseur de fréquence, dit »de référence«, 38 ayant un facteur de division constant (R).

Il est à remarquer ici que le second comparateur de phase 25 peut avantageusement être formé au moyen d'un circuit intégré hybride du type MC-4344 ou MC-4044 de la société américaine »MOTOROLA«, appelé »PHASE-FREQUENCY DETECTOR«.

La sortie du second comparateur 25 alimente un second filtre passe-bas 28 et un amplificateur à courant continu 29 en cascade, qui peuvent être combinés en un filtre passe-bas actif à amplificateur opérationnel intégré, par exemple (voir l'article précité de BREMENSON et al.), dont la sortie alimente la seconde entrée du circuit additionneur analogique 39 permettant de refermer et de combiner ainsi les boucles de démodulation et de synthèse de fréquence à travers l'unique oscillateur commandé par tension 150. La fréquence de coupure haute du second filtre passe-bas 28 (inférieure à 1 kHz dans l'article de BREMENSON et al. précité) qui est inversement proportionelle à sa constante de temps d'intégration, est choisie ici, de préférence inférieure à la fréquence de trame (50 ou 60 Hz) des signaux de télévision, afin que le temps de réponse plus long de la boucle de synthèse 110 permette à l'oscillateur commandé par tension (VCO) 150 de fournir une fréquence variable en fonction de l'amplitude instantanée du signal vidéo-composite et de la sous-pourteuse de son superposée, fournis par le premier filtre passe-bas 160, de sorte qu'il puisse suivre les excursions de fréquence de l'onde porteuse modulée, appliquée à l'entrée de la boucle de démodulation 120, autour d'une fréquence centrale déterminée par la boucle de synthèse 110. Cette fréquence centrale est alors peu différente de la fréquence de repos (sans signal modulant) de l'onde porteuse du canal choisi à l'aide du diviseur programmable, car la plage de capture du dispositif de synthèse et de démodulation de fréquence combinées suivant l'invention est, grâce à la présence de la boucle de synthèse 110 qui permet de maintenir la fréquence de l'oscillateur commandé 150 à une valeur déterminée même en l'absence d'onde reçue, rendue notablement plus étroite que celle du démodulateur à boucle de verrouillage de phase 15 classique de la figure 1.

On notera ici que, du fait du gain élevé de la boucle de démodulation 120, déterminé par la sensibilité de l'oscillateur à fréquence commandé par une tension 150, qui est de l'ordre de 100 MHz/volt, l'amplificateur vidéo-fréquence 170 peut éventuellement être transféré en aval de la sortie 19 du démodulateur (voir l'article précité de BREMENSON et al.).

Dans un mode de réalisation avantageuse du récepteur muni d'un dispositif d'accord et de démodulation comprenant un synthétiseur de fréquence et un démodulateur de fréquence combinés, à boucles à verrouillage de phase (PLL), le circuit de commande numérique 24 qui commande le facteur de division variable (N) du diviseur programmable 23 sert également à commander l'accord du filtre passe-bande accordable 90 de telle sorte que la fréquence centrale de sa bande passante étroite (20 MHz) corresponde sensiblement à la fréquence de repos de l'onde porteuse du canal choisi et à celle de l'oscillateur commandé 150 telle que commandé par la boucle de synthèse 110 (en l'absence de signal d'entrée). A cette fin, les sorties parallèles du circuit 24 sont également réunies aux entrées d'adresse parallèles d'une mémoire morte programmable 35 (appelée »programmable read-only memory« ou PROM dans la littérature anglo-américaine) dont les sorties de données parallèles alimentent un convertisseur numérique-analogique 36. La mémoire 35 est préalablement programmée de manière à fournir, lorsqu'elle est adressée par un nombre correspondant à un numéro de canal de transmission déterminé, un nombre composé de digits binaires et correspondant à un niveau de tension continue d'accord à la sortie 37 du convertisseur N/A 36, telle que la fréquence centrale du filtre 90 devient sensiblement égale à celle du canal choisi. La sortie 37 du convertisseur N/A 36 est alors reliée à l'entrée de commande d'accord 91 du filtre accordable 90 de façon à polariser à l'envers la ou les diodes à capacité variable qu'il comporte.

Il est à remarquer que la gamme de fréquences de fonctionnement dépend de la gamme des facteurs de division du diviseur programmable 23.

On notera ici que le dispositif de synthèse et de démodulation de fréquence combinées peut s'appliquer également à un récepteur d'ondes modulées en fréquence situées dans une bande de fréquences inférieures à 1,5 GHz. Dans ce cas on peut omettre le transposeur d'entrée 3,4 de la tête haute-fréquence 6 et relier l'antenne 1 directement à un amplificateur radio-fréquence à faible facteur de bruit et, éventuellement, à gain commandable, qui peut être précédé et/ou suivi d'un filtre accordable analogue au filtre 90.

**Revendications**

1. Dispositif de synthèse et de démodulation de fréquence pour un récepteur d'ondes modulées en fréquence, comprenant: un oscillateur à fréquence variable commandée par tension (150); un premier comparateur de phase (140) dont une entrée reçoit l'onde modulée en fréquence et dont l'autre entrée reçoit l'onde fournie par l'oscillateur (150); un premier filtre passe-bas ou passe-bande (160) alimenté par la sortie du premier comparateur de phase (140); un prédiviseur de fréquence (22) à facteur de division (P) constante et un diviseur programmable (23) à facteur de division (N) variable commandé numériquement par un circuit de commande (24), connectés en cascade; un second comparateur de phase (25) dont une entrée est alimentée par le diviseur programmable (23) et dont l'autre entrée reçoit une onde de référence de fréquence stable provenant d'un oscillateur (26) à quartz (27); et un second filtre passe-bas (28) alimenté par la sortie du second comparateur de phase (25), caractérisé en ce que la sortie de l'oscillateur (150) alimente également le prédiviseur (22) et en ce que les sorties du premier (160) et du second (28) filtre alimentent respectivement deux entrées d'un circuit additionneur analogique (39) dont la sortie alimente l'entrée de commande de fréquence de l'oscillateur (150) de sortie que les deux boucles à verrouillage de phase respectivement de synthèse (110) et de démodulation (120) de fréquence sont combinées du fait qu'elles se referment à travers le même oscillateur (150).

2. Dispositif suivant la revendication 1, caractérisé en ce que la fréquence de coupure haute du second filtre passe-bas (28) de la boucle de synthèse (110) est choisie inférieure à la fréquence minimale du signal modulant l'onde porteuse reçue qui pour un signal vidéo-composite est constituée par la fréquence de trame, la bande passante du premier filtre (160) de la boucle de démodulation (120) englobant alors le spectre de fréquences entier du signal vidéo-composite et de la sous-porteuse de son superposée.

3. Dispositif suivant l'une des revendications précédentes, caractérisé en ce qu'il comporte, en outre, inséré dans la voie de l'onde porteuse reçue, en amont du premier comparateur de phase (140), un filtre passe-bande accordable (90) à l'aide d'une tension continue d'accord dans une bande de fréquences comprenant une pluralité de canaux de transmission, dont la bande passante comprend le spectre de l'onde porteuse et de ses composantes de modulation et qui est accordé simultanément avec le choix du canal à l'aide du circuit de commande numérique (24) commandant le diviseur programmable (23).

4. Dispositif suivant la revendication 3, caractérisé en ce que les sorties parallèles du circuit de commande numérique (24) alimentent également les entrées d'adresse parallèles d'une mémoire morte programmable (35) dont les sorties parallèles alimentent les entrées parallèles d'un convertisseur numérique-analogique (36) qui fournit la tension d'accord à l'entrée de commande (91) de l'accord du filtre accordable (90).

5. Dispositif suivant l'une des revendications précédentes, caractérisé en ce qu'il comporte, en outre, inséré dans la voie de l'onde porteuse reçue, en amont du premier comparateur de phase (140), un élément à gain variable (31) comprenant une entrée de commande de gain (34) alimentée par un signal de commande de gain proportionnel à l'amplitude crête de l'onde porteuse prélevée en aval de cet élément, qui affecte le gain de celui-ci de façon à maintenir l'amplitude du signal de sortie de cet élément sensiblement constante pour une large gamme d'amplitudes de ses signaux d'entrée.

6. Dispositif suivant la revendication 5, caractérisé en ce que l'élément à gain variable (31) est constitué par un atténuateur variable à diodes PIN.

7. Récepteur d'ondes modulées en fréquence, caractérisé en ce qu'il comporte un dispositif de synthèse et de démodulation de fréquence combinées, suivant l'une des revendications précédentes.

8. Récepteur suivant la revendication 7, caractérisé en ce qu'il comporte, inséré dans la voie de l'onde porteuse, en amont de l'entrée du dispositif de synthèse et de démodulation combinées, un transposeur de fréquence comprenant un mélangeur hétérodyne (3) alimenté par un oscillateur à fréquence constante (4) et par l'onde porteuse modulée, reçue.

**Patentansprüche**

1. Vorrichtung zur Frequenzsynthese und -demodulation für einen Empfänger von frequenzmodulierten Schwingungen, mit: einem Oszillator (150), dessen variable Frequenz durch eine Spannung gesteuert ist; einem ersten Phasenvergleicher (140), wovon ein Eingang die frequenzmodulierte Schwingung und der andere die von dem Oszillator (150) gelieferte Schwingung empfängt; einem ersten Tiefpaßfilter oder Bandpaßfilter (160), das durch den Ausgang des ersten Phasenkomparators (140) gespeist wird; einem Frequenzvorteiler (22) mit konstantem Teilungsfaktor (P) und einem programmierbaren Teiler (23), dessen variabler Teilungsfaktor (N) digital durch eine Steuerschaltung (24) gesteuert ist, wobei diese in Kaskade geschaltet sind; einem zweiten Phasenkomparator (25), wovon ein Eingang durch den programmierbaren Teiler (23) gespeist wird und der andere eine Referenzschwingung stabiler Frequenz aus einem Oszillator (26) empfängt, der einen Quarz (27) aufweist; und einem zweiten Tiefpaßfilter (28), das durch den Ausgang des zweiten Phasenkomparators (25) gespeist ist; dadurch gekennzeichnet, daß der Ausgang des Oszillators (150) ferner den Vorteiler (22) speist und daß die Ausgänge des ersten (160) und des zweiten (28) Filters jeweils einen von zwei Eingängen einer analogen Addierschaltung (39) speisen, deren Ausgang den Frequenzsteuereingang des Ausgangsoszillators (150) speist, und daß die zwei Phasenverriegelungsschleifen, nämlich die Frequenzsyntheseschleife (110) und die Frequenzdemodulationsschleife (120), aufgrund der Tatsache, daß sie sich über denselben Oszillator (150) schließen, kombiniert sind.

2. Vorrichtung nach Anspruch 1, dadurch gekennzeichnet, daß die obere Grenzfrequenz des zweiten Tiefpaßfilters (28) der Syntheseschleife (110) niedriger als die minimale Frequenz des Signals gewählt ist, welche die empfangene Trägerschwingung moduliert und für ein zusammengesetztes Videosignal aus der Bildfrequenz gebildet ist, wobei das Durchlaßband des ersten Filters (160) der Demodulationsschleife (120) das gesamte Frequenzspektrum des zusammengesetzten Videosignals und den überlagerten Ton-Hilfsträger umfaßt.

3. Vorrichtung nach einem der vorstehenden Ansprüche, dadurch gekennzeichnet, daß sie ferner ein in den Weg der empfangenen Trägerschwingung vor dem ersten Phasenkomparator (140) eingefügtes Bandfilter (90) umfaßt, das durch eine Abstimm-Gleichspannung in einem Frequenzband abstimmbar ist, welches eine Mehrzahl von Übertragungskanälen enthält und dessen Durchlaßband das Spektrum der Trägerschwingung und ihrer Modulationskomponenten enthält, wobei dieses Filter gleichzeitig mit der Wahl des Kanals mittels der digitalen Steuerschaltung (24) abgestimmt wird, welche den programmierbaren Teiler (23) steuert.

4. Vorrichtung nach Anspruch 3, dadurch gekennzeichnet, daß die parallelen Ausgänge der digitalen Steuerschaltung (24) ferner die parallelen Adreßeingänge eines programmierbaren Festwertspeichers (35) speisen, dessen parallele Ausgänge die parallelen Eingänge eines Digital/Analog-Umsetzers (36) speisen, der die Abstimmspannung an den Abstimm-Steuereingang (91) des abstimmbaren Filters (90) liefert.

5. Vorrichtung nach einem der vorstehenden Ansprüche, dadurch gekennzeichnet, daß sie ferner ein in den Weg der empfangenen Trägerschwingung vor dem ersten Phasenkomparator (140) eingefügtes Element mit variabler Verstärkung (31) enthält, welches einen Verstärkungssteuereingang (34) aufweist, der durch ein Verstärkungssteuersignal gespeist ist, das proportional zum Scheitelwert der Amplitude der Trägerschwingung ist, die hinter diesem Element abgegriffen wird und die Verstärkung dieses Elementes derart beeinflußt, daß die Amplitude des Ausgangssignals dieses Elementes ungefähr konstant bleibt, und zwar für einen großen Amplitudenbereich seiner Eingangssignale.

6. Vorrichtung nach Anspruch 5, dadurch gekennzeichnet, daß das Element (31) mit variabler Verstärkung aus einem variablen Dämpfungsglied mit PIN-Dioden gebildet ist.

7. Empfänger für frequenzmodulierte Schwingungen, dadurch gekennzeichnet, daß er eine Vorrichtung zur kombinierten Frequenzsynthese und -demodulation gemäß einem der vorstehenden Ansprüche enthält.

8. Empfänger nach Anspruch 7, dadurch gekennzeichnet, daß er einen in den Weg der Trägerschwingung vor dem Eingang der Vorrichtung zur kombinierten Synthese und Demodulation eingefügten Frequenzumsetzer umfaßt, der einen Überlagerungsmischer (3) enthält, welcher durch einen Oszillator (4) mit konstanter Frequenz und durch die empfangene modulierte Trägerschwingung gespeist ist.

## Claims

1. Frequency synthesizer and demodulation device for a receiver of frequency-modulated waves, comprising: a voltage-controlled variable frequency oscillator (150); a first phase comparator (140) one input of which receives the frequency-modulated wave and the other input of which receives the wave supplied by the oscillator (150); a first low-pass or band-pass filter (160) fed by the output of the first phase comparator (140); a frequency prescaler (22) having a constant division factor (P) and a programmable divider (23) having a variable division factor (N) numerically conrolled by a control circuit (24), which are connected in cascade; a second phase comparator (25) one input of which is supplied by the programmable divider (23) and the other input of which receives a reference wave of stable frequency from a quartz (27) oscillator (26); and a second low-pass filter (28) fed by the output of the second phase comparator (25); characterized in that the output of the oscillator (150) likewise feeds the prescaler (22) and in that the outputs of the first (160) and second (28) filters feed two inputs of an analog adder circuit (39), respectively, the output of which feeds the frequency control input of the output oscillator (150) so that the two phase locked loops, i. e. the frequency synthesizer (110) and demodulation (120) loops, are combined with each other by being closed through the same oscillator (150).

2. Device according to claim 1, characterized in that the upper cut-off frequency of the second low-pass filter (28) of the synthesizer loop (110) is selected to be less than a minimum frequency of the signal modulating the received carrier wave which, for a composite video signal, is formed by the frame frequency, the pass-band of the first filter (160) of the demodulation loop (120) comprising the entire frequency spectrum of the composite video signal and of the superposed sound sub-carrier.

3. Device according to any of the preceding claims, characterized in that it further comprises, inserted into the path of the received carrier wave and upstream from the first phase comparator (140), a tunable bandpass filter (90) tuned by means of a d. c. tuning voltage within a frequency band comprising a plurality of transmission channels, and the pass-band of which comprises the spectrum of the carrier wave and its modulation components, and which is tuned simultaneously with the selection of the channel by means of the numerical control circuit (24) controlling the programmable divider (23).

4. Device according to claim 3, characterized in that the parallel outputs of the numerical conrol circuit (24) likewise feed the parallel address inputs of a programmable read-only memory (35) the parallel outputs of which feed the parallel inputs of a digital/analog converter (36) supplying the tuning voltage to the tuning control input (91) of the tunable filter (90).

5. Device according to any of the preceding claims, characterized in that it further comprises, inserted into the path of the received carrier wave and upstream from the first phase comparator (140), a variable gain member (31) comprising a gain control input (34) fed by a gain control signal which is proportional to the crest amplitude of the carrier wave derived downstream from this member, to condition the gain thereof in a manner to maintain substantially constant the amplitude of the output signal of this member within a large range of amplitude of its input signals.

6. Device according to claim 5, characterized in that the variable gain member (31) is formed by a variable PIN diode attenuator.

7. Receiver for frequency-modulated waves, characterized in that it comprises a combined frequency synthesizer and demodulation device according to any of the preceding claims.

8. Receiver according to claim 7, characterized in that comprises, inserted into the path of the carrier wave upstream from the input of the combined synthesizer and demodulation device, a frequency translator comprising a superhet mixer (3) fed by a constant frequency oscillator (4) and by the received modulated carrier wave.

Fig. 1

FIG. 2